## Europäisches Patentamt
## European Patent Office
## Office européen des brevets

(19)

(11) Veröffentlichungsnummer: **0 286 158**
**B1**

(12)

# EUROPÄISCHE PATENTSCHRIFT

(45) Veröffentlichungstag der Patentschrift: **23.01.91**

(51) Int. Cl.⁵: **C 23 C 16/44, C 30 B 25/14**

(21) Anmeldenummer: **88200522.6**

(22) Anmeldetag: **09.03.88**

(54) **Gassystem zur präzisen Injektion von Materialien mit niedrigem Dampfdruck in Niederdruck- oder Vacuumsysteme.**

(30) Priorität: **09.03.87 DE 3707507**

(43) Veröffentlichungstag der Anmeldung:
**12.10.88 Patentblatt 88/41**

(45) Bekanntmachung des Hinweises auf die
Patenterteilung:
**23.01.91 Patentblatt 91/04**

(84) Benannte Vertragsstaaten:
**DE FR GB**

(56) Entgegenhaltungen:
**US-A-4 640 221**

**JOURNAL OF CRYSTAL GROWTH, Band 77, Nrs. 1-3, September 1986, Seiten 73-78, Elsevier Science Publishers B.V., Amsterdam, NL; R.S. SILLMON et a.: "An ultra-fast gas delivery system for producing abrupt compositional switching in IMVPE"**

**PATENT ABSTRACTS OF JAPAN, Band 10, Nr. 71 (C-334)2128r, 20 März 1986; & JP-A-60 211 072 (MATSUSHITA DENKI SANGYO K.K.) 23-10-1985**

(73) Patentinhaber: **Siemens Aktiengesellschaft
Wittelsbacherplatz 2
D-8000 München 2 (DE)**

(72) Erfinder: **Schlötterer, Heinrich, Dr. rer. nat.
Andreas-Wagner-Strasse 11 a
D-8011 Putzbrunn (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Bei der Gasphasenepitaxie und der Molekularstrahlepitaxie unter Verwendung von gasförmigen Quellen werden Halbleiterverbindungen in gasförmigem Aggregatzustand in ein Niederdruck oder Vakuumsystem injiziert, um dort auf einer erhitzten Einkristallsubstratoberfläche dünne Schichten aufzuwachsen. Zu diesem Zweck ist eine Apparatur erforderlich, mit der an der Austrittsöffnung in die Vakuumkammer ein in ausreichender Höhe genau dosierbarer Teilchenfluß einstellbar ist. Insbesondere wenn mehrere solche Gaszuleitungen vorhanden sind und verschiedene Halbleiterverbindungen, insbesondere metallorganische Verbindungen, in vorgegebenem stöchiometrischem Verhältnis in die Injektionskammer eingebracht werden sollen, muß die Austrittsrate sehr genau dosierbar sein. Nach dem Stand der Technik kann eine solche Apparatur dadurch betrieben werden, daß der reine Dampf des zu injizierenden Materials druckgeregelt direkt in ein Vakuumsystem injiziert wird. Wegen der unvermeidlichen Leitungswiderstände führt dies aber bei Materialien mit kleinem Sättigungsdampfdruck (z.B. Triäthylindium hat bei 20° C nur etwa 0,25 mbar.) dazu, daß nur sehr kleine Materialflüsse erzielbar sind. Nach dem Stand der Technik kann ein höherer Materialfluß dadurch erreicht werden, daß ein Trägergas, z.B. $H_2$, durch einen Behälter, in dem das zu injizierende Material in flüssigem oder festem Aggregatzustand vorliegt, hindurchgeleitet wird (sogenanntes bubbling) und dieses Trägergas sich mit dem sich im oberen Teil des Behälters ansammelnden im gasförmigen Aggregatzustand befindlichen Material vermischt und dieses Gemisch mit einem gewissen Druck in die Vakuumkammer, in der niedriger Druck oder Vakuum durch ein Pumpensystem aufrechterhalten wird, eingeleitet wird.

Bei einer derartigen Apparatur muß die durchströmende Gasmenge eingestellt werden. Dies geschieht üblicherweise dadurch, daß vor dem Behälter mit der Halbleiterverbindung eine Massflow-control-Einrichtung angebracht ist, die das durchströmende Trägergas mißt. Ein Nachteil dieses Verfahrens ist, daß die Meßgenauigkeit dieser Mass-flow-control-Apparaturen bei kleinen Flüssen (weniger als 1 $cm^3$/min) zu gering ist. Demgegenüber läßt sich der in den Leitungen vorhandene Druck sehr genau messen.

Aufgabe der vorliegenden Erfindung ist es, eine Apparatur anzugeben, mit der eine bei ausreichendem Materialfluß präzise dosierbare Injektion von Materialien mit geringem Dampfdruck in Niederdruck- oder Vakuumsysteme möglich ist.

Diese Aufgabe wird bei einer erfindungsgemäßen Apparatur durch die Merkmale des Anspruches 1 gelöst.

Eine erfindungsgemäße Apparatur besteht aus folgenden Teilen: Für die Aufnahme des zu injizierenden Materials, z.B. halbmetallorganische Verbindungen, die in flüssigem Aggregatzustand vorliegen, ist ein hierzu dimensionierter Behälter vorgesehen. Für diesen Behälter sind Zu- und Ableitungen für das Durchströmen mit Trägergas vorgesehen. In der Zuleitung und in der Leitung zwischen Behälter und Vakuumkammer sind jeweils Steuerventile eingebaut. Das Steuerventil in der Zuleitung für das Trägergas kann über eine elektronische Regelapparatur gesteuert werden. Diese Regelapparatur besteht im wesentlichen aus einem Druckmesser, der den Druck in der aus dem Behälter führenden Leitung mißt und mit einem vorgebbaren Sollwert vergleicht. Hinter dem Steuerventil, das in dieser zwischen dem Behälter und der Vakuumkammer befindlichen Leitung eingebaut ist, ist eine entsprechende Regeleinrichtung vorgesehen. Hier liegt der Druckmeßanschluß direkt hinter dem Steuerventil.

Zur Erklärung der Funktionsweise dieser Apparatur ist zu bemerken, daß sich der Gesamtdruck in der aus dem Behälter führenden Ableitung aus den Partialdrucken des Trägergases und des in gasförmigem Aggregatzustand befindlichen zu injizierenden Materials zusammensetzt. Die für die Funktionsweise der Apparatur maßgebende Größe ist aber nicht der Druck, sondern der Teilchenfluß. Der Fluß ist eine Funktion des Drukkes. Je nach Gasdichte und geometrischen Abmessungen der Leitung liegt viskose Strömung oder molekulare Strömung oder eine Zwischenform dieser Strömungen vor. Die viskose Strömung ist durch eine Proportionalität zwischen Fluß und Quadrat des Druckes gekennzeichnet, während die molekulare oder KnudsenStrömung durch eine Proportionalität zwischen Fluß und Druck gekennzeichnet ist. Bei den für die Anwendung typischen Drucken im Bereich von etwa 0,1 bis 10 mbar liegt in der Regel eine Proportionalität zwischen dem Fluß und einer höheren als ersten Potenz des Druckes vor. Die Beziehung zwischen Fluß und Druck ist folglich überlinear. Das führt dazu, daß mit einer Erhöhung des Druckes in der Leitung der Fluß überproportional stark ansteigt. Falls z.B. eine quadratische Abhängigkeit besteht, ist bei fehlendem Trägergas der Fluß proportional zum Quadrat des Dampfdruckes der zu injizierenden Materialien. Mischt man zu diesem Gas ein Trägergas mit dem gleich hohen Partialdruck, so ist der Gesamtdruck doppelt so hoch wie im ersten Fall. Aufgrund der quadratischen Abhängigkeit des Flusses vom Druck ergibt sich aber eine Vervierfachung des gesamten Flusses. Der gesamte Fluß setzt sich nun zu gleichen Teilen aus den Flüssen des Trägergases und der gasförmigen Injektionsma terialien zusammen. Auf diese Weise ist erreicht, daß mit dem Zufügen des Trägergases eine Verdoppelung des Materialflußes einhergeht. Bei niedrigerer als quadratischer Abhängigkeit, d.h. einer Proportionalität zwischen dem Fluß und einer Druckpotenz mit einem Exponenten zwischen 1 und 2 ist der eintretende Effekt in entsprechend verminderter Weise gleichfalls anzutreffen. Bei Materialien mit niedrigem Dampfdruck erhält man auf diese Weise die Möglichkeit, mittels Durchpumpen eines Trägergases den Fluß des zu injizierenden Materials zu erhöhen.

Der Dampfdruck des zu injizierenden Materials wird konstant gehalten, indem der Behälter mit diesem Material in einem Temperaturbad oder dergleichen auf konstanter Temperatur gehalten wird. Der Gesamtdruck wird gemessen und dient der Steuerung des in der Zuleitung für das Trägergas eingebauten Steuerventils, womit auf diese Weise der Gesamtdruck konstant gehalten werden oder auf die jeweils vorgebbare Höhe eingestellt werden kann. Durch das zweite Steuerventil kann der Druck des Gasgemisches und damit der in die Vakuumkammer einströmende Teilchenfluß individuell geregelt werden.

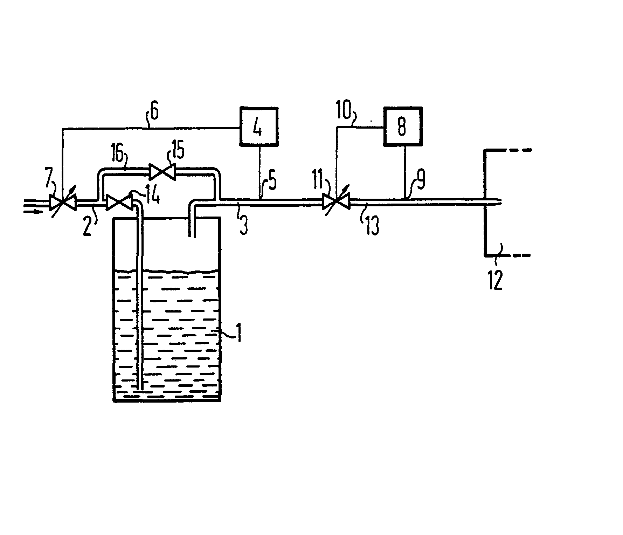

Es folgt die Beschreibung eines Ausführungsbeispiels anhand der Figur.

Ein Behälter 1 dient zur Aufnahme der zu injizierenden Materialien in flüssiger oder fester Form. In diesen Behälter führt eine Zuleitung 2 für Trägergas. Diese Zuleitung 2 mündet dicht über dem Boden des Behälters 1. Aus diesem Behälter 1 führt eine Ableitung 3, deren Öffnung sich in dem Behälter 1 weit oben unterhalb der Abdeckung oder des Verschlußdeckels befindet. Auf diese Weise ist es möglich, Trägergas über die Zuleitung 2 in das in dem Behälter 1 befindliche Material einzuleiten, wobei dieses Trägergas in Blasen in dem Material aufsteigt, sich mit dem bei Dampfdruckgleichgewicht über dem Material in Gasphase befindlichen Material vermischt und durch die Öffnung der Ableitung 3 den Behälter 1 verläßt.

In der Zuleitung 2 ist ein erstes Steuerventil 7 installiert. Am Ende der Ableitung 3 befindet sich ein zweites Steuerventil 11. Zwischem dem Behälter 1 und diesem zweiten Steuerventil 11 ist ein erster Druckmeßanschluß 5 vorgesehen. Ein mit diesem ersten Druckmeßanschluß 5 verbundener erster Druckmesser 4 mißt die Höhe des Druckes in diesem ersten Druckmeßanschluß 5, wertet diesen Druck aus, vergleicht mit dem Sollwert und regelt über eine erste Signalleitung 6 das erste Steuerventil 7, so daß sich der vorgegebene Gasdruck an der Stelle des ersten Druckmeßanschlusses 5 einstellt und konstant gehalten wird. Bei Verwendung von Präzisionsdruckaufnehmern, ist dies mit einer Genauigkeit von besser als ± 0,1 % realisierbar.

Die Ableitung 3 setzt sich hinter dem zweiten Steuerventil 11 in eine Injektionsleitung 13 zum Einleiten des Gases in eine zu dem Niederdruck- oder Vakuumsystem gehörende Vakuumkammer 12 fort. In dieser Injektionsleitung 13 ist ein zweiter Druckmeßanschluß 9 vorgesehen, der mit einem zweiten Druckmesser 8 verbunden ist. Dieser zweite Druckmesser 8 mißt den Druck im zweiten Druckmeßanschluß 9, wertet ihn aus und steuert über eine zweite Signalleitung 10 das zweite Steuerventil 11. Durch diesen Regelmechanismus läßt sich im zweiten Druckmeßanschluß 9 ein vorgegebener Druck und damit ein vorgegebener Teilchenfluß genau einstellen. Der Druck im zweiten Druckmeßanschluß 9 kann dabei niemals den Druck im ersten Druckmeßanschluß 5 übersteigen.

Eine weitere Ausgestaltung sieht einen zusätzlichen Bypass 16 zur Überbrückung des Behälters 1 vor. In der Zuleitung 2 ist zwischen dem ersten Steuerventil 7 und dem Behälter 1 ein Sperrventil 14 eingebaut. Zwischen dem ersten Steuerventil 7 und diesem Sperrventil 14 zweigt eine Leitung von der Zuleitung 2 ab. Diese Leitung mündet in der Ableitung 3 zwischen den Behälter 1 und dem zweiten Steuerventil 11 und bildet den Bypass 16. Zur Absperrung des Bypasses 16 ist in dieser Leitung mindestens ein Ventil 15 eingebaut. Zur Vermeidung von ungespülten Texträumen kann es vorteilhaft sein, jeweils ein Ventil an den Anschlußstellen des Bypasses anzubringen.

Die Betriebsweise dieser Apparatur gestaltet sich zweckmäßig so, daß entweder der Druck im ersten Druckmeßanschluß 5 über den ersten Druckmesser 4 und die erste Signalleitung 6 zur Steuerung des ersten Steuerventiles 7 konstant gehalten wird; der Druck in der Injektionsleitung 13 wird dann im zweiten Druckmeßanschluß 9 bestimmt und über den angeschlossenen zweiten Druckmesser 8, die zweite Signalleitung 10 und das zweite Steuerventil 11 auf den Wert eingestellt, der dem jeweils erforderlichen Materialstrom entspricht. Eine zweite Betriebsweise besteht darin, den Druck im zweiten Druckmeßanschluß 9 über den angeschlossenen Regelmechanismus konstant zu halten und über eine Variation des Druckes im ersten Druckmeßanschluß 5 mittels des dort angeschlossenen Regelmechanismus für das erste Steuerventil 7 das Verhältnis aus Trägergas und Nutzgas zu verändern, wobei wieder der physikalische Effekt einer nichtlinearen Abhängigkeit des Teilchenflusses von dem Druck ausgenutzt wird.

**Patentansprüche**

1. Vorrichtung mit mindestens einer Niederdruck-/Vakuumkammer (12) und mindestens einem Behälter (1) zur Aufnahme jeweiligen zu injizierenden Materials in flüssiger oder fester Form, wobei jeweils eine bis dicht über den Boden des jeweiligen Behälters (1) reichende Zuleitung (2) für ein Trägergas und eine oben unter der Abdeckung beginnende Ableitung (3) für ein Gemisch aus dem Trägergas und dem in Gasphase befindlichen zu injizierenden Material vorgesehen ist,
dadurch gekennzeichnet,
daß in der Zuleitung (2) ein erstes Steuerventil (7) vorhanden ist,
daß am Ende der Ableitung (3) ein zweites Steuerventil (11) vorhanden ist,
daß hinter dem zweiten Steuerventil (11) eine Injektionsleitung (13) zur Weiterleitung des Gasstromes in eine Niederdruck-/Vakuumkammer (12) vorhanden ist,
daß in der Ableitung (3) ein erster Druckmeßanschluß (5) vorgesehen ist,

daß in der Injektionsleitung (13) ein zweiter Druckmeßanschluß (9) vorhanden ist,

daß an dem ersten Druckmeßanschluß (5) ein erster Druckmesser (4) angeschlossen ist,

daß an dem zweiten Druckmeßanschluß (9) ein zweiter Druckmesser (8) angeschlossen ist,

daß von dem ersten Druckmesser (4) zu dem ersten Steuerventil (7) eine erste Signalleitung (6) führt,

daß von dem zweiten Druckmesser (8) zu dem zweiten Steuerventil (11) eine zweite Signalleitung (10) führt,

daß über die Steuerventile (7, 11) die Drücke an den Druckmeßanschlüssen (5, 9) einstellbar sind und

daß die Steuerventile (7, 11) über die Signalleitungen (6, 10) durch die Druckmesser (4, 8) steuerbar sind.

2. Vorrichtung nach Anspruch 1, dadurch gekennzeichnet,

daß zwischen der Zuleitung (2) und der Ableitung (3) ein Bypass (Überbrückung) (16) mit einem Ventil (15) eingebaut ist und

daß sich in der Zuleitung (2) hinter dem Anschluß des Bypasses (16) ein Sperrventil (14) befindet.

**Revendications**

1. Appareillage comprenant au moins une chambre sous basse pression/vide (12) et au moins une cuve (1) de réception de substances à injecter sous forme liquide ou sous forme solide, alors que sont prévus un conduit d'amenée (2) débouchant juste au-dessus du fond de la cuve (1), ainsi qu'un conduit d'évacuation (3), issu dans le haut, en-dessous du couvercle, et destiné à un mélange du gaz véhicule et de la substance à injecter se trouvant en phase gazeuse, caractérisé en ce que,

il est prévu, dans le conduit d'amenée (2), une première vanne de commande (7),

il est prévu, à l'extrémité du conduit d'évacuation (3), une deuxième vanne de commande (11),

il est prévu, en aval de la deuxième vanne de commande (11), un conduit d'injection (13) pour envoyer le courant gazeux dans une chambre sous basse pression/vide (12),

il est prévu, dans le conduit d'évacuation (3), un premier raccord de mesure de la pression (5),

il est prévu, dans le conduit d'injection (13), un deuxième raccord de mesure de la pression (9),

au premier raccord de mesure de la pression (5), est raccordé un premier manomètre (4),

au deuxième raccord de mesure de la pression (9), est raccordé un deuxième manomètre (8),

un premier conducteur de signaux (6) mène du premier manomètre (4) à la première vanne de commande (7),

un deuxième conducteur de signaux (10) mène du deuxième manomètre (8) à la deuxième vanne de commande (11),

les pressions au niveau des raccords de mesure de pression (5, 9) peuvent être réglées par les vannes de commande (7 et 11) et

les vannes de commande (7 et 11) peuvent être commandées par les manomètres (4, 8), par l'intermédiaire des conducteurs de signaux (6, 10).

2. Appareillage suivant la revendication 1, caractérisé,

en ce que, entre le conduit d'amenée (2) et le conduit d'évacuation (3), est monté un by-pass (dérivation) (16) avec une vanne (15), et

une vanne d'arrêt (14) se trouve dans le conduit d'amenée (2), en aval du raccord de la dérivation (16).

**Claims**

1. Device comprising at least one low-pressure/vacuum chamber (12) and at least one container (1) for accommodating respective material to be injected in liquid or solid form, in which arrangement in each case a feed line (2) extending to close above the bottom of the respective container (1) for a carrier gas and an outlet line (3) beginning at the top underneath the cover for a mixture of the carrier gas and the material to be injected, which is in the gas phase, is provided, characterized in that in the feed line (2) a first control valve (7) is present,

that at the end of the outlet line (3) a second control valve (11) is present,

that behind the second control valve (11) an injection line (13) for forwarding the gas flow into a low-pressure/vacuum chamber (12) is present,

that in the outlet line (3) a first pressure measuring connection (5) is provided,

that in the injection line (13) a second pressure measuring connection (9) is present,

that a first pressure gauge (4) is connected to the first pressure measuring connection (5),

that a second pressure gauge (8) is connected to the second pressure measuring connection (9),

that a first signal line (6) leads from the first pressure gauge (4) to the first control valve (7),

that a second signal line (10) leads from the second pressure gauge (8) to the second control valve (11),

that the pressures at the pressure measuring connections (5, 9) can be adjusted via the control valves (7, 11) and that the control valves (7, 11) can be controlled by the pressure gauges (4, 8) via the signal lines (6, 10).

2. Device according to Claim 1, characterized in that a bypass (16) with a valve (15) is installed between the feed line (2) and the outlet line (3) and that a shut-off valve (14) is located in the feed line (2) behind the connection of the bypass (16).

EP 0 286 158 B1